# EUROPÄISCHE PATENTSCHRIFT

(11) **EP 3 748 307 B1**
(45) Veröffentlichungstag und Bekanntmachung des Hinweises auf die Patenterteilung: **17.11.2021**
(21) Anmeldenummer: 19177921.4
(22) Anmeldetag: 03.06.2019
(51) Int. Cl.: G01D 11/30

(54) **FELDGERÄT MIT BEFESTIGUNGSADAPTER**
FIELD DEVICE WITH FIXING ADAPTER
APPAREIL DE TERRAIN DOTÉ D'UN ADAPTATEUR DE FIXATION

(43) Veröffentlichungstag der Anmeldung: 09.12.2020
(73) Patentinhaber: VEGA Grieshaber KG, 77709 Wolfach (DE)
(72) Erfinder: KECH, Günter, 77709 Wolfach (DE)
(74) Vertreter: Maiwald Patent- und Rechtsanwaltsgesellschaft mbH

(56) Entgegenhaltungen:
- DE-A1-102008 025 863
- DE-A1-102012 203 400
- DE-A1-102015 122 177

## Beschreibung

### Gebiet der Erfindung

Die vorliegende Erfindung betrifft ein Befestigungssystem für ein Feldgerät, umfassend ein Feldgerät und einen Befestigungsadapter, die Verwendung eines Befestigungsadapters in einem solchen System, sowie die Verwendung eines Feldgeräts in einem solchen System.

### Hintergrund der Erfindung

Feldgeräte werden in der Prozessautomation und der Prozessindustrie vielfach zum Überwachen und Ermitteln von einer oder mehreren Prozessvariablen oder Messgrößen eingesetzt. Beispielsweise können Feldgeräte zur Bestimmung eines Drucks eines Mediums, eines Füllstands eines Mediums, eines Durchflusses eines Mediums, einer Fließgeschwindigkeit eines Mediums, einer Temperatur oder anderer Prozessvariablen eingesetzt werden. Feldgeräte werden dabei vermehrt in Netzwerke eingebunden und beispielsweise mit Computern, Smartphones, Laptops oder dergleichen vernetzt. Diese vernetzten Feldgeräte können dabei Mess-, Parametrier- oder Diagnosedaten an Rechner-, Auswerte- oder Visualisierungseinheiten übermitteln.
DE 10 2015 122177 A1 offenbart einen Sensoradapter für eine Vorrichtung zur Bestimmung und/oder Überwachung zumindest einer Prozessgröße eines Mediums in einem Behälter mit einer Messsonde.
DE 10 2012 203400 A1 offenbart eine Vorrichtung mit einer Sensorspitze, die in axialer Richtung mit einem teilweise rotationssymmetrischen Gehäuse verbunden ist.
DE 10 2008 025863 A1 offenbart einen optischen Sensor mit einem Gehäuse und einer Befestigungsvorrichtung zur einstellbaren Befestigung des Gehäuses an einem dritten Teil.

Die Gehäuse solcher Feldgeräte sind üblicherweise auf eine bestimmte Befestigungssituation angepasst. Eine davon abweichende Befestigungssituation führt dazu, dass das Gehäuse an eine solche Einbausituation angepasst werden muss, um eine optimale Positionierung des Feldgeräts bereitstellen zu können. In der Praxis werden Feldgeräte dabei außerhalb eines Behälters, beispielsweise an einer Behälterwandung oder an einer Decke oberhalb eines Behälters, oder auch innerhalb eines Behälters angeordnet werden, wobei sich bei den bisherigen Lösungen hier auch die Orientierung bzw. Ausrichtung der in den Feldgeräten vorgesehenen Messeinheiten ändern kann, je nachdem, ob das Feldgerät an einer Behälterwandung, in Deckenmontage oder innerhalb eines Behälters angeordnet wird.

In diesem Zusammenhang hat sich nunmehr herausgestellt, dass ein weiterer Bedarf besteht, eine Installation eines Feldgeräts bzw. eine Anpassung an eine jeweilige Einbausituation zu vereinfachen. Es ist daher Aufgabe der vorliegenden Erfindung, eine einfachere Möglichkeit zur Installation eines Feldgeräts bereitzustellen. Darüber hinaus ist es Aufgabe der vorliegenden Erfindung, eine einfache Möglichkeit bereitzustellen, um eine ansonsten notwendige Anpassung der Ausrichtung der in den Feldgeräten vorgesehenen Messeinheiten zu vermeiden bzw. eine solche zumindest zu vereinfachen.

Diese und andere Aufgaben, die beim Lesen der folgenden Beschreibung noch genannt werden oder vom Fachmann erkannt werden können, werden durch den Gegenstand der unabhängigen Ansprüche gelöst. Die abhängigen Ansprüche bilden den zentralen Gedanken der vorliegenden Erfindung in besonders vorteilhafterweise weiter.

### Zusammenfassung der Erfindung

Ein erfindungsgemäßes Befestigungssystem für ein Feldgerät umfasst: zumindest ein Feldgerät, umfassend ein erstes Gehäuseteil; zumindest einen Befestigungsadapter, umfassend ein zweites Gehäuseteil zur verliersicheren Aufnahme des ersten Gehäuseteils; wobei das erste Gehäuseteil zumindest ein Befestigungsmittel und/oder das zweite Gehäuseteil zumindest ein Befestigungsmittel umfasst; wobei das bzw. die Befestigungsmittel derart angeordnet sind, dass das Feldgerät in einer ersten Ausrichtung mit dem zweiten Gehäuseteil und in einer zweiten Ausrichtung mit dem zweiten Gehäuseteil in Eingriff bringbar ist, wobei eines der ersten und zweiten Gehäuseteile erste Befestigungsmittel und zweite Befestigungsmittel umfasst und das andere der ersten und zweiten Gehäuseteile dritte Befestigungsmittel umfasst; wobei das dritte Befestigungsmittel in einer ersten Ausrichtung des Feldgeräts mit dem ersten Befestigungsmittel und in einer zweiten Ausrichtung des Feldgeräts mit dem zweiten Befestigungsmittel in Eingriff bringbar ist.

Unter einem Feldgerät gemäß der vorliegenden Erfindung ist jede Einheit zu verstehen, die zur Überwachung und Erfassung von einer oder mehrerer Prozessvariablen eingesetzt wird und beschränkt sich nicht auf bestimmte Feldgeräte, solange diese Feldgeräte in unterschiedlichen Einbausituationen eingesetzt werden können.

Erfindungsgemäß ist zumindest an einem der beiden Gehäuseteile ein Befestigungsmittel derart angeordnet, dass das Feldgerät in zumindest zwei Ausrichtungen im oder am Befestigungsadapter verliersicher angeordnet werden kann. Mit anderen Worten schlägt die vorliegende Erfindung vor, ein System mit einem Befestigungsadapter bereitzustellen, an dem das Feldgerät bzw. das Gehäuse des Feldgeräts in zumindest zwei unterschiedlichen Positionierungen angebracht werden kann, sodass zunächst der Befestigungsadapter, beispielsweise an einer Behälterwandung oder in Deckenmontage befestigt werden kann und anschließend die Orientierung bzw. Ausrichtung des Feldgeräts durch die unterschiedlichen Anordnungsmöglichkeiten des Feldgeräts an oder im Befestigungsadapter entsprechend an die Einbausituation angepasst werden kann. Diesbezüglich ist darauf hinzuweisen, dass sich die vorliegende Erfindung nicht auf eine bestimmte Einbausituation beschränkt, insbesondere kann ein erfindungsgemäßes Befestigungssystem an einem Behälter, außerhalb eines Behälters, innerhalb eines Behälters, an einer Decke, an einer Rohranordnung oder in einem Kanal oder dergleichen eingesetzt werden. Auch ist die vorliegende Erfindung nicht auf eine bestimmte Anzahl von Befestigungsmitteln oder auf deren konkrete Anordnung am Feldgerät und/oder am Befestigungsadapter beschränkt. Von Bedeutung ist in diesem Zusammenhang lediglich, dass durch das oder die Befestigungsmittel eine verlierischere Anordnung des Feldgeräts am oder im Befestigungsadapter in zumindest zwei Orientierungen/Ausrichtungen ermöglicht wird.

In einer Ausführungsform kann entweder das erste oder das zweiten Gehäuseteil erste Befestigungsmittel und zweite Befestigungsmittel umfassen, wobei das andere Gehäuseteil dann dritte Befestigungsmittel umfasst und zwar derart, dass das dritte Befestigungsmittel in einer ersten Ausrichtung des Feldgeräts mit dem ersten Befestigungsmittel und in einer zweiten Ausrichtung des Feldgeräts mit dem zweiten Befestigungsmittel in Eingriff bringbar ist. In diesem Zusammenhang ist es weiterhin bevorzugt, dass das erste Befestigungsmittel und das zweite Befestigungsmittel am ersten Gehäuseteil und das dritte Befestigungsmittel am zweiten Gehäuseteil vorgesehen. Mit anderen Worten ist es in diesem Zusammenhang bevorzugt, dass am Feldgerät bzw. am Gehäuse des Feldgeräts zumindest zwei Befestigungsmittel vorgesehen sind, die mit dem dritten Befestigungsmittel des Befestigungsadapters jeweils in Eingriff bringbar sind, d.h. das dritte Befestigungsmittel des Befestigungsadapters ist in einer ersten Positionierung bzw. Ausrichtung des Feldgeräts mit dem ersten Befestigungsmittel des Feldgeräts und in einer zweiten Positionierung bzw. Ausrichtung des Feldgeräts mit dem zweiten Befestigungsmittel des Feldgeräts in Eingriff bringbar.

Vorteilhafterweise sind das erste und das zweite Befestigungsmittel an gegenüberliegenden Seiten des ersten Gehäuseteils angeordnet. In diesem Zusammenhang ist es weiterhin bevorzugt, dass die Befestigungsmittel in Eckbereichen des ersten Gehäuseteils und/oder in Eckbereichen einer Aufnahme des zweiten Gehäuseteils angeordnet sind. In dieser bevorzugten Ausfiihrungsform umfasst das Gehäuse des Feldgeräts somit zwei Befestigungsmittel, die vorzugsweise derart in den Eckbereichen des Gehäuses des Feldgeräts vorgesehen sind, dass das Feldgerät in eine Aufnahme des Befestigungsadapters eingeführt werden kann und die jeweiligen Befestigungsmittel des Feldgeräts mit dem Befestigungsmittel des Befestigungsadapters Wechsel wirken können. Alternativ können die Befestigungsmittel auch umlaufend an oder in den Gehäuseteilen vorgesehen sein.

Ferner ist es bevorzugt, dass das erste und das zweite Befestigungsmittel spiegelsymmetrisch bezüglich einer Ebene angeordnet sind, sodass das Feldgerät in der ersten Ausrichtung um 180° DEG gedreht im Vergleich zur zweiten Ausrichtung am zweiten Gehäuseteil anordenbar ist. Durch eine derartige Anordnung der Befestigungsmittel kann die Ausrichtung des Feldgeräts bzw. der im Feldgerät vorgesehenen Messeinheit auf verschiedene Einbausituationen angepasst werden, beispielsweise einem Einbau an einem Behälter und einem Einbau in Deckenmontage. Häufig unterscheiden sich Einbausituationen dadurch, dass das Feldgerät um 180° DEG gedreht angeordnet werden muss, beispielsweise bei einer Montage an einem Behälter und einer Montage an einer Decke, beispielsweise oberhalb eines Behälter (Deckenmontage). Darüber hinaus ist es bevorzugt, dass das Gehäuse des Feldgeräts im Wesentlichen symmetrisch bezüglich einer Ebene ausgebildet ist, um die das Feldgerät für die unterschiedlichen Ausrichtungen bzw. Anordnungen im Befestigungsadapter gedreht werden kann. In diesem Zusammenhang muss das Gehäuse des Feldgeräts allerdings nicht vollständig symmetrisch ausgebildet sein, sondern nur hinsichtlich der jeweilig in Anlage bringbaren Flächen und Befestigungsmittel. In diesem Zusammenhang ist darauf hinzuweisen, dass es sich bei einer spiegelsymmetrischen, rotationsymmetrischen oder sonstigen Symmetrie lediglich um besonders bevorzugte Ausgestaltungen handelt. Jedoch ist eine solche Symmetrie zur Verwirklichung der vorliegenden Erfindung nicht notwendig, solange durch das oder die Befestigungsmittel eine verlierischere Anordnung des Feldgeräts am oder im Befestigungsadapter in zumindest zwei Ausrichtungen ermöglicht wird.

Vorzugsweise sind die Befestigungsmittel als korrespondierende Rastverbindungen, Bajonettverbindungen, Schnappverbindungen, Feder-/Nutverbindungen, umlaufende Verbindungen oder Schraubverbindungen ausgebildet. In diesem Zusammenhang ist es ferner bevorzugt, dass lösbare Verbindungen eingesetzt werden, d.h. Verbindungen, die es erlauben, dass das Feldgerät vom Befestigungsadapter wieder gelöst werden kann. Darüber hinaus ist es von Vorteil, dass die eingesetzten Verbindungen es erlauben, zunächst den Befestigungsadapter an einem Einbauort zu befestigen und anschließend das Feldgerät mit dem Befestigungsadapter zu verbinden. Darüber hinaus können auch unterschiedliche Befestigungsmittel/-elemente oder dergleichen in einem Befestigungssystem eingesetzt werden, solange dadurch eine verliersichere Anordnung des Feldgeräts am oder im Befestigungsadapter in zumindest zwei Ausrichtungen möglich ist.

Vorteilhafterweise umfasst ein jeweiliges Befestigungsmittel zumindest zwei Befestigungselemente, die vorzugsweise gegenüberliegend zueinander angeordnet sind. Mit anderen Worten ist es bevorzugt, dass ein Befestigungsmittel beispielsweise durch zwei Schnapp- oder Rastverbindungen bereitgestellt wird, die in gegenüberliegenden Eckbereichen eines der Gehäuse angeordnet sind. Die eingesetzten Befestigungselemente können dabei punktuell wirkende Verbindungen, wie beispielsweise bei Schraubverbindungen, oder linear wirkende Verbindungen sein, wie beispielsweise bei länglich ausgebildeten Rastverbindung oder Feder-/ Nutverbindung. Alternativ oder zusätzlich kann ein Befestigungsmittel allerdings auch nur ein mittig angeordnetes Befestigungselement, beispielsweise eine Schnappverbindung, eine Schraubverbindung oder dergleichen umfassen, wenn dadurch eine verliersichere Anordnung des Feldgeräts am oder im Befestigungsadapter in zumindest zwei Ausrichtungen möglich ist.

Vorzugsweise ist das erste Gehäuseteil des Feldgeräts derart in das zweite Gehäuseteil des Befestigungsadapters aufnehmbar, dass beide Gehäuseteile im verbundenen Zustand eine gemeinsame Basisfläche ausbilden, wobei die gebildete Basisfläche eine planare Fläche oder eine gekrümmte Fläche ist. In diesem Zusammenhang ist es weiterhin bevorzugt, dass das Feldgerät derart in einer Aufnahme des Befestigungsadapters aufgenommen wird, dass das Feldgerät mehr oder weniger vollständig in der Aufnahme des Befestigungsadapters angeordnet werden kann und der Befestigungsadapter und das Feldgerät zumindest eine gemeinsame Basisfläche bilden. Diese Basisfläche kann vorteilhafterweise als Anlagefläche verwendet werden, um den Befestigungsadapter bzw. das Feldgerät beispielsweise an einem Behälter anzuordnen und an diesem zu befestigen. Die Geometrie der Basisfläche ist dabei vorzugsweise an die Geometrie des jeweiligen Einsatzorts angepasst. Soll das Befestigungssystems beispielsweise auf einer planen Oberfläche eines Behälters angeordnet werden, ist es bevorzugt, dass die Basisfläche korrespondierend planar ausgebildet ist, wird das Befestigungssystems demgegenüber auf einer gekrümmten Fläche angeordnet, beispielsweise an einer Rohrleitung, ist es bevorzugt, dass die Basisfläche eine korrespondierend ausgebildete gekrümmte Fläche ist. Eine Befestigung des Befestigungssystems bzw. des Befestigungsadapters am Einbauort kann beispielsweise mittels Kabelbindern, Riemen, Bändern oder anderen Befestigungsmittel erfolgen. Alternativ oder zusätzlich besteht die Möglichkeit das Befestigungssystems bzw. den Befestigungsadapter mittels einer Klebe-, Schraub- oder einer Schweißverbindung an einem Einbauort, beispielsweise an einer Oberfläche eines Behälters, zu befestigen.

Vorteilhafterweise umfasst das Feldgerät eine Lage- bzw. Orientierungserfassungseinheit, eingerichtet um zu ermitteln, ob das Feldgerät beispielsweise in der ersten oder der zweiten Ausrichtung am zweiten Gehäuseteil angeordnet ist. Dadurch besteht die Möglichkeit, bei einer Signalauswertung die jeweilige Ausrichtung des Befestigungssystems bzw. des Feldgeräts, vorzugsweise automatisch, zu berücksichtigen. Dies ist insbesondere bei den typischen Positionierungen des Befestigungssystems an einem Behälter oder in Deckenmontage von Vorteil, da die Orientierung des Feldgeräts sich bei diesen beiden Positionierungen typischerweise unterscheiden. Demgemäß kann in diesem Fall anhand der Orientierung des Feldgeräts am oder im Befestigungsadapter darauf zurückgeschlossen werden, ob das Befestigungssystems an einem Behälter oder in Deckenmontage angeordnet ist, sodass bei der Signalauswertung (automatisch) berücksichtigt werden kann, ob ein ausgesendetes Signal benachbart durch eine (Behälter-) Wandung geführt wird oder nicht. Dadurch kann der jeweilige Signalweg im Rahmen der Signalverarbeitung entsprechend berücksichtigt werden, sodass mögliche Fehlinterpretationen vermieden werden können. In diesem Zusammenhang ist es bevorzugt, dass die Lageerfassungseinheit bspw. einen Reed-Kontakt oder einen Hall-Sensor umfasst, der eingerichtet ist, um mit einer am Befestigungsadapter angeordneten Magneteinheit wechselzuwirken, um die Ausrichtung des Feldgeräts zu ermitteln. Beide genannten Sensoren stellen dabei eine einfache und zuverlässige Möglichkeit bereit, die Ausrichtung des Feldgeräts in bzw. an dem Befestigungsadapter zu ermitteln, und damit vorzugsweise ebenfalls die Möglichkeit, um zu ermitteln, wie dass Befestigungssystem befestigt bzw. angeordnet ist.

Vorzugsweise ist das Feldgerät eine Füllstandsmesseinheit, die eingerichtet ist, einen Füllstand basierend auf einer Laufzeitmessung eines abgestrahlten und auf die Füllstandsmesseinheit reflektierten Signals, vorzugsweise ein Radarsignal oder ein Mikrowellensignal, zu bestimmen. In diesem Zusammenhang ist es weiterhin bevorzugt, dass das Feldgerät eingerichtet ist, bei der Signalauswertung zu berücksichtigen, ob das Feldgerät in der ersten oder zweiten Ausrichtung angeordnet ist. Gerade in der Ausgestaltung des Feldgeräts als Füllstandsmesseinheit ist es bevorzugt, dass die Ausrichtung des Feldgeräts bei der Signalauswertung berücksichtigt wird. Demgemäß ist es besonders bevorzugt, dass eine erste Ausrichtung des Feldgeräts für eine Anordnung des Befestigungssystems an einem Behälter und eine zweite Ausrichtung des Feldgeräts für eine Anordnung des Befestigungssystems in Deckenmontage vorgesehen ist.

Ferner bezieht sich die vorliegende Erfindung auf eine Verwendung eines Befestigungsadapters, umfassend ein Gehäuseteil zur verliersicheren Aufnahme eines Gehäuseteils eines Feldgeräts in einem oben beschriebenen System. Schließlich bezieht sich die vorliegende Erfindung auch auf eine Verwendung eines Feldgeräts, umfassend ein Gehäuseteil zur verliersicheren Aufnahme in einem Gehäuseteil eines Befestigungsadapters in einem oben beschriebenen System.

### Beschreibung einer bevorzugten Ausführungsform

Nachfolgend wird eine detaillierte Beschreibung der Figuren gegeben. Darin zeigt:
- **Figur 1**: eine schematische Ansicht eines Befestigungssystems gemäß einer ersten bevorzugten Ausführungsform der vorliegenden Erfindung mit einem Feldgerät und einem Befestigungsadapter, wobei der Befestigungsadapter in dieser Ausführungsform zwei Befestigungsmittel und das Feldgerät ein Befestigungsmittel umfassen;
- **Figur 2**: eine schematische Ansicht des in Figur 1 gezeigten Befestigungssystems in einer ersten Einbausituation mit einer ersten Ausrichtung des Feldgeräts im Befestigungsadapter;
- **Figur 3**: eine schematische Ansicht des in Figur 1 gezeigten Befestigungssystems in einer zweiten Einbausituation mit einer zweiten Ausrichtung des Feldgeräts im Befestigungsadapter;
- **Figur 4**: eine schematische Ansicht eines nicht erfindungsgemäßen Befestigungssystems mit einem Feldgerät und einem Befestigungsadapter, wobei das Feldgerät und der Befestigungsadapter in dieser Ausführungsform jeweils nur ein Befestigungsmittel umfassen;
- **Figur 5**: eine schematische Ansicht eines nicht erfindungsgemäßen Befestigungssystems mit einem Feldgerät und einem Befestigungsadapter, wobei eine Befestigung des Feldgeräts am Befestigungsadapter in dieser Ausführungsform mit nur einem Befestigungsmittel erfolgt; und
- **Figur 6**: schematische Ansicht eines Befestigungssystem gemäß einer vierten bevorzugten Ausführungsform der vorliegenden Erfindung mit einem Feldgerät und einem Befestigungsadapter, wobei eine Befestigung des Feldgeräts am Befestigungsadapter in dieser Ausfiihrungsform mit zwei Befestigungsmitteln erfolgt.

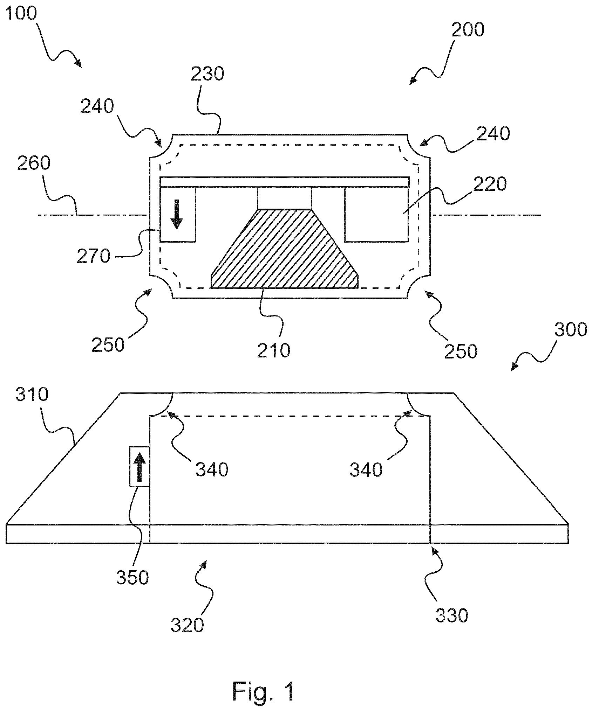

Figur 1 zeigt eine schematische Ansicht eines Befestigungssystems 100 umfassend ein Feldgerät 200 und einen Befestigungsadapter 300.

Das Feldgerät 200 ist in der gezeigten besonders bevorzugten Ausfiihrungsform als Füllstandsmesseinheit ausgebildet und umfasst eine Signalerfassungseinheit 210 eine Signalauswerteeinheit 220. Die Signalerfassungseinheit 210 ist dabei eingerichtet, einen Füllstand basierend auf einer Laufzeitmessung eines von der Signalerfassungseinheit 210 abgestrahlten und auf dieses wieder reflektierte Signal zu bestimmen, wobei als Signal vorzugsweise ein Radarsignal oder ein Mikrowellensignal eingesetzt wird.

Ferner umfasst das Feldgerät 200 ein Gehäuseteil 230, in dem die jeweiligen Einheiten angeordnet bzw. befestigt sind. Das Gehäuseteil 230 umfasst darüber hinaus zwei Befestigungselemente 240, die zusammen ein erstes Befestigungsmittel bilden, und die an oberen gegenüberliegenden Seiten bzw. Eckbereichen des Gehäuseteils 230 vorgesehen sind. Weiterhin umfasst das Gehäuseteil 230 ein zweites Befestigungsmittel, bereitgestellt durch zwei Befestigungselemente 250, die an unteren gegenüberliegenden Seiten bzw. Eckbereichen des Gehäuseteils 230 vorgesehen sind. Wie in Figur 1 gut zu erkennen ist, ist das Gehäuseteil 230 im wesentlichen spiegelsymmetrisch zu einer Ebene 260 ausgebildet, d.h. bei einer Rotation des Gehäuseteils 230 bzw. des Feldgeräts 200 um 180° DEG können die den oberen Befestigungselemente 240 (erstes Befestigungsmittel) in die Position der unteren Befestigungselemente 250 gebracht werden. Schließlich umfasst das Feldgerät 200 in der gezeigten besonders bevorzugten Ausführungsform noch eine Lageerfassungseinheit 270 in Form eines Reed-Kontaktes oder eines Hall-Sensors, um eine Ausrichtung des Feldgeräts 200 an oder im Befestigungsadapter 300 zu ermitteln. Alternativ können die Befestigungselemente 240, 250 auch als umlaufende Befestigungselemente 240 ausgebildet sein.

Der Befestigungsadapter 300 umfasst ein Gehäuseteil 310, an dem bzw. in dem ein Aufnahmebereich 320 vorgesehen ist, in dem das Feldgerät 200 angeordnet werden kann, d.h. die Geometrie des Aufnahmebereichs 320 des Befestigungsadapters 300 ist derart ausgebildet bzw. dimensioniert, dass das Gehäuseteil 230 des Feldgeräts 200 im Aufnahmebereich 320 angeordnet werden kann, wobei es bevorzugt ist, dass das Gehäuseteil 230 des Feldgeräts 200 vollständig in den Aufnahmebereich 320 eingeführt werden kann, sodass die beiden Gehäuseteile 230, 310 zumindest eine gemeinsame Basisfläche 330 bilden. Das Gehäuseteil 310 umfasst weiterhin ein drittes Befestigungsmittel in Form zweier gegenüberliegender Befestigungselemente 340, die derart ausgebildet sind, dass diese mit den Befestigungsmitteln 240, 250 des Feldgeräts 200 verliersicher in Eingriff gebracht werden können. Die Befestigungselemente 340 sind dabei in gegenüberliegenden Eckbereichen des Aufnahmebereichs 320 angeordnet. In einer ersten Orientierung des Feldgeräts 200 können dabei die ersten Befestigungsmittel 240 mit den dritten Befestigungsmittel 340 in Eingriff gebracht werden und in einer zweiten Orientierung des Feldgeräts 200 können dabei die zweiten Befestigungsmittel 250 mit den dritten Befestigungsmittel 340 in Eingriff gebracht werden. In der gezeigten besonders bevorzugten Ausführungsform ist die erste Orientierung des Feldgeräts 200 um 180° DEG gedreht im Vergleich zur zweiten Orientierung des Feldgeräts 200, mit denen das Feldgerät 200 im Aufnahmebereich 320 im Befestigungsadapter 300 angeordnet bzw. befestigt werden kann.

Ferner umfasst der Befestigungsadapter 300 eine Magneteinheit 350, die eingerichtet ist, um mit der Lageerfassungseinheit 270 des Feldgeräts wechselzuwirken.

In diesem Zusammenhang ist darauf hinzuweisen, dass die ersten und zweiten Befestigungsmittel 240, 250 in einer alternativen Ausgestaltung der vorliegenden Erfindung auch am Befestigungsadapter 300 vorgesehen sein könnten, wobei in diesem Fall die dritten Befestigungsmittel 340 am Feldgerät 200 vorzusehen wären. Darüber hinaus besteht die Möglichkeit die Lageerfassungseinheit 270 anstatt im Feldgerät 200 im Befestigungsadapter 300 vorzusehen. In diesem Fall müsste die korrespondierende Magneteinheit 350 am Feldgerät 200 vorgesehen werden.

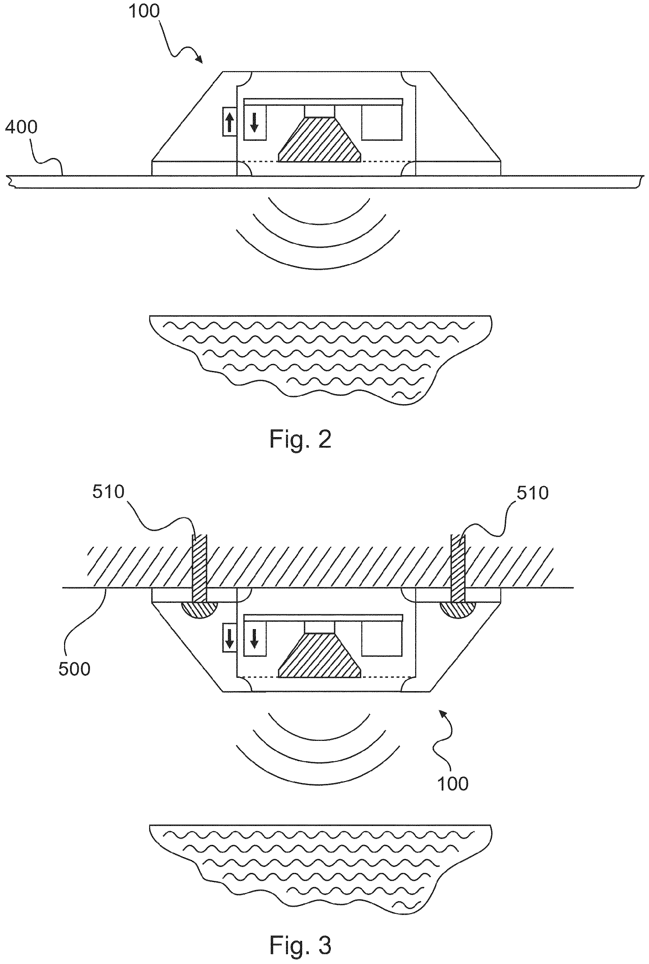

Figur 2 zeigt das Befestigungssystem 100 aus Figur 1 in einer ersten Einbausituation. In dieser ist das Befestigungssystems 100 außerhalb eines Behälters auf einer Außenfläche/Wandung 400 des Behälters angeordnet. In der gezeigten Anordnung ist das Feldgerät 200 in der Aufnahme 320 des Befestigungsadapters 300 derart angeordnet, dass beide Gehäuseteile 230, 310 eine gemeinsame, plane Basisfläche 330 bilden. An dieser Basisfläche 330 ist das Befestigungssystems 100 an der Außenfläche 400 befestigt, wobei eine solche Befestigung beispielsweise mittels einer Klebeverbindung, einer Schweißverbindung, einem doppelseitigen Klebeband oder ähnlichem erfolgen kann. Durch die Lageerfassungseinheit 270 und der mit dieser wechselwirkenden Magneteinheit 350 kann ermittelt werden, in welcher Ausrichtung bzw. Orientierung das Feldgerät 200 in dem Befestigungsadapter 300 angeordnet ist, und dass das Befestigungssystems 100 an einer Außenfläche 400 eines Behälters angeordnet ist, sodass dies durch die Signalauswerteeinheit 220 berücksichtigt werden kann.

Figur 3 zeigt das Befestigungssystems 100 aus Figur 1 in einer zweiten Einbausituation. In dieser ist das Befestigungssystems 100 beispielsweise an einer Decke über einem Behälter an einer Fläche 500 angeordnet. Wiederum ist das Feldgerät 200 in der Aufnahme 320 des Befestigungsadapters 300 derart angeordnet, dass beide Gehäuseteile 230, 310 eine gemeinsame, plane Basisfläche 330 bilden. Das Befestigungssystems 100 ist mit der Basisfläche 330 an der Innenfläche 500 befestigt, wobei eine solche Befestigung hier mittels entsprechender Schraubverbindungen 510 vorgesehen ist. Wiederum kann durch die Lageerfassungseinheit 270, die mit der Magneteinheit 350 wechselwirkt, ermittelt werden, in welcher Ausrichtung das Feldgerät 200 in dem Befestigungsadapter 300 angeordnet ist, und daher, dass das Befestigungssystems 100 in Deckenmontage angeordnet ist, sodass dies wiederum durch die Signalauswerteeinheit 220 berücksichtigt werden kann, d.h. im Nahbereich des Feldgeräts 200 ist in der Messstrecke keine Wandung oder dergleichen angeordnet.

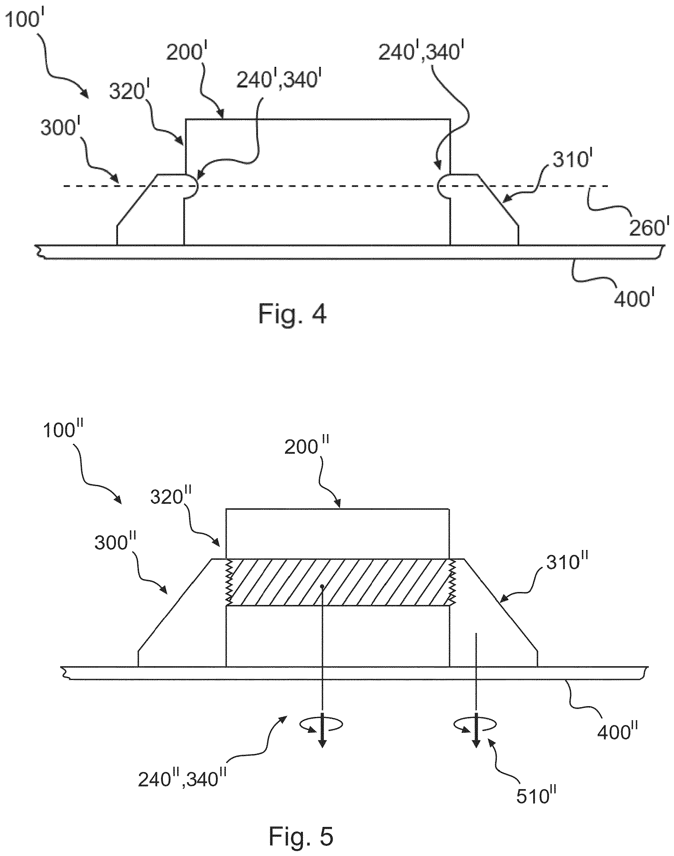

Figur 4 zeigt eine schematische Ansicht eines nicht erfindungsgemäßen Befestigungssystems 100', das beispielhaft an einer Außenfläche/Wandung 400' eines Behälters angeordnet ist, mit einem Feldgerät 200' und einem Befestigungsadapter 300', wobei im Unterschied zu obiger Ausführungsform das Feldgerät 200' und der Befestigungsadapter 300' jeweils nur ein Befestigungsmittel 240', 340' umfassen. Hinsichtlich der Erläuterungen der jeweiligen Teile wird ergänzend auf obige Erläuterungen verwiesen. Der Befestigungsadapter 300' umfasst ebenfalls einen Aufnahmebereich 320', in dem das Feldgerät 200' in zwei Orientierungen aufgenommen werden kann. Wie in Figur 4 gut zu erkennen ist, sind die Befestigungsmittel 240', 340' in etwa mittig an den Gehäuseteilen angeordnet, beispielsweise an einer zentralen Symmetrieebene 260'. Die Befestigungsmittel 240', 340' können dabei beispielsweise mittels einer Rast-, Schnappverbindung, einem umlaufenden Verbindungsmittel oder ähnlichem bereitgestellt werden.

Figur 5 zeigt eine schematische Ansicht eines nicht erfindungsgemäßen Befestigungssystems 100" mit einem Feldgerät 200" und einem Befestigungsadapter 300", wobei das Befestigungssystem 100" wiederum beispielhaft an einer Wandung 400" eines Behälters angeordnet ist. Hinsichtlich der Erläuterungen der jeweiligen Teile wird wiederum ergänzend auf obige Erläuterungen verwiesen. Der Befestigungsadapter 300" umfasst einen Aufnahmebereich 320", in dem das Feldgerät 200" in zwei Orientierungen aufgenommen werden kann. Wie in Figur 5 gut zu erkennen ist, ist das Befestigungsmittel 240', 340' hier beispielhaft durch eine Schraubverbindung bereitgestellt, so dass das Feldgerät 200" in zwei Orientierungen mit dem Befestigungsadapter 300" und/oder mit der Wandung 400" verschraubt werden kann. Zur Befestigung der Befestigungsadapters 300" kann dieser beispielsweise auch nur an einer Seite an der Wandung 400" befestigt werden, hier beispielhaft durch eine Schraubverbindung 510".

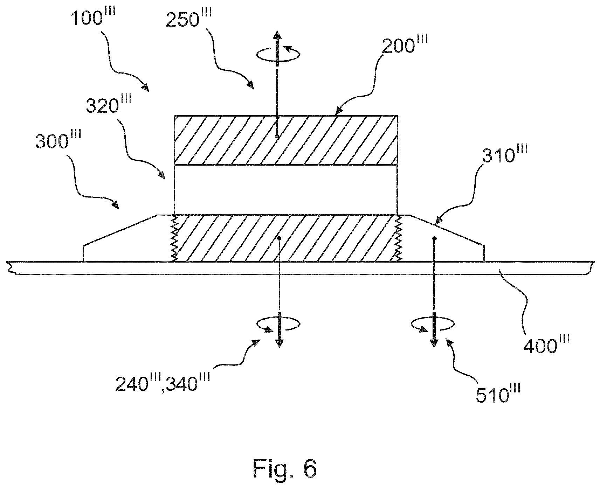

Figur 6 zeigt eine schematische Ansicht eines Befestigungssystem 100'" gemäß einer vierten bevorzugten Ausfuhrungsform der vorliegenden Erfindung mit einem Feldgerät 200'" und einem Befestigungsadapter 300"', wobei das Befestigungssystem 100"' wiederum beispielhaft an einer Wandung 400'" eines Behälters angeordnet ist. Hinsichtlich der Erläuterungen der jeweiligen Teile wird wiederum ergänzend auf obige Erläuterungen verwiesen. Der Befestigungsadapter 300'" umfasst einen Aufnahmebereich 320'", in dem das Feldgerät 200'" in zwei Orientierungen aufgenommen werden kann. Wie in Figur 6 gut zu erkennen ist, sind die Befestigungsmittel 240'", 340'", 250'" hier beispielhaft durch zwei Verschraubungsmöglichkeiten bereitgestellt, d.h. in einer ersten Orientierung kann das Feldgerät 200'" mit einer ersten Schraubverbindung 240'", 340'" und in einer zweiten Position kann das Feldgerät 200'" um 180° DEG gedreht werden und mit einer zweiten Schraubverbindung 250"', 340'" am Befestigungsadapter 300'" und/oder an der Wandung 400'" befestigt werden. Im gezeigten Ausfiihrungsbeispiel ist der Befestigungsadapters 300" hier wiederum beispielsweise an einer Seite an der Wandung 400'" befestigt, hier beispielhaft durch eine Schraubverbindung 510'".

Es wird darauf hingewiesen, dass die vorliegende Erfindung nicht auf den Einsatz eines bestimmten Feldgeräts 100 in Kombination mit einem Befestigungsadapter 200 beschränkt ist. Die vorliegende Erfindung wird allerdings besonders bevorzugt mit einem Feldgerät 100 in Form einer Füllstandsmesseinheit eingesetzt, die basierend auf einer Laufzeitmessung eines abgestrahlten und auf die Füllstandsmesseinheit reflektierten Signals einen Füllstand bestimmt. Dies basiert insbesondere darauf, dass derartige Füllstandsmesseinheit typischerweise an einem Behälter auf einer Außenfläche/-wandung oder oberhalb eines Behälters in Deckenmontage angeordnet werden. Die vorliegende Erfindung ist darüber hinaus nicht auf die vorhergehend gezeigten, bevorzugten Ausführungsformen beschränkt, solange sie vom Gegenstand der folgenden Ansprüche umfasst sind, insbesondere ist die vorliegende Erfindung nicht auf eine bestimmte Anzahl von Befestigungsmitteln oder auf deren konkrete Anordnung am Feldgerät und/oder am Befestigungsadapter beschränkt. Auch ist für die Verwirklichung der vorliegenden Erfindung keine spezifische Symmetrie des Feldgeräts, des Befestigungsadapters oder der Anordnung der Befestigungsmittel an den jeweiligen Gehäuseteilen notwendig. Auch kann die Position der Befestigungsmittel variieren und ist nicht auf die gegenüberliegenden Kanten des Gehäuses beschränkt. Von Bedeutung ist in diesem Zusammenhang lediglich, dass durch das oder die Befestigungsmittel eine verlierischere Anordnung des Feldgeräts am oder im Befestigungsadapter in zumindest zwei Orientierungen/Ausrichtungen ermöglicht wird. Darüber hinaus erkennt der Fachmann, dass jeweilige Teile der obigen Ausführungsbeispiele je nach konkreten Einsatzanforderungen auch mit- und/oder untereinander kombiniert werden können.

### Bezugszeichenliste:

- 100: Befestigungssystems
- 200: Feldgerät
- 210: Signalerfassungseinheit
- 220: Signalauswerteeinheit
- 230: erstes Gehäuseteil
- 240: erste Befestigungselemente (erstes Befestigungsmittel)
- 250: zweite Befestigungselemente (zweites Befestigungsmittel)
- 260: Symmetrieebene
- 270: Lageerfassungseinheit
- 300: Befestigungsadapter
- 310: zweites Gehäuseteil
- 320: Aufnahmebereich
- 330: gemeinsame Basisfläche
- 340: dritte Befestigungselemente (drittes Befestigungsmittel)
- 350: Magneteinheit
- 400: Außenfläche eines Behälters
- 500: Innenfläche eines Behälters
- 510: Schraubverbindungen

## Patentansprüche

1. Befestigungssystem (100) für ein Feldgerät (200), umfassend:
zumindest ein Feldgerät (200), umfassend ein erstes Gehäuseteil (230);
zumindest einen Befestigungsadapter (300), umfassend ein zweites Gehäuseteil (310) zur verliersicheren Aufnahme des ersten Gehäuseteils (230) ;
wobei eines der ersten und zweiten Gehäuseteile (230,310) erste Befestigungsmittel (240) und zweite Befestigungsmittel (250) umfasst und das andere der ersten und zweiten Gehäuseteile (230, 310) dritte Befestigungsmittel (340) umfasst;
wobei die Befestigungsmittel derart angeordnet sind, dass das Feldgerät (200) in einer ersten Ausrichtung mit dem zweiten Gehäuseteil (310) und in einer zweiten Ausrichtung mit dem zweiten Gehäuseteil (310) in Eingriff bringbar ist;
wobei das dritte Befestigungsmittel (340) in einer ersten Ausrichtung des Feldgeräts (200) mit dem ersten Befestigungsmittel (240) und in einer zweiten Ausrichtung des Feldgeräts (200) mit dem zweiten Befestigungsmittel (250) in Eingriff bringbar ist.

2. Befestigungssystem (100) nach Anspruch 1, wobei das erste Befestigungsmittel (240) und zweite Befestigungsmittel (250) am ersten Gehäuseteil (230) und das dritte Befestigungsmittel (340) am zweiten Gehäuseteil (310) vorgesehen sind.

3. Befestigungssystem (100) nach einem der vorhergehenden Ansprüche 1 oder 2, wobei das erste und zweite Befestigungsmittel (240, 250) an gegenüberliegenden Seiten des ersten Gehäuseteils (230) angeordnet sind, und wobei es bevorzugt ist, dass die Befestigungsmittel (240, 250, 340) in Eckbereichen des ersten Gehäuseteils (230) und/oder in Eckbereichen einer Aufnahme (320) des zweiten Gehäuseteils (310) angeordnet sind.

4. Befestigungssystem (100) nach einem der vorhergehenden Ansprüche 1 bis 3, wobei das erste und zweite Befestigungsmittel (240, 250) spiegelsymmetrisch bezüglich einer Ebene (260) angeordnet sind, so dass das Feldgerät (200) in der ersten Ausrichtung um 180° DEG gedreht im Vergleich zur zweiten Ausrichtung am zweiten Gehäuseteil (310) anordenbar ist.

5. Befestigungssystem (100) nach einem der vorhergehenden Ansprüche, wobei die Befestigungsmittel (240, 250, 340) als korrespondierende Rastverbindungen, Bajonettverbindungen, Schnappverbindungen, Feder-/Nutverbindungen und/oder Schraubverbindungen ausgebildet sind.

6. Befestigungssystem (100) nach einem der vorhergehenden Ansprüche, wobei das erste Gehäuseteil (230) des Feldgeräts (200) derart in das zweite Gehäuseteil (310) des Befestigungsadapters (200) aufnehmbar ist, dass beide Gehäuseteile (230, 310) im verbundenen Zustand eine gemeinsame Basisfläche (330) ausbilden, wobei die gebildete Basisfläche (330) vorzugsweise eine planare Fläche (330) oder eine gekrümmte Fläche ist.

7. Befestigungssystem (100) nach einem der vorhergehenden Ansprüche, wobei das Feldgerät (200) eine Lageerfassungseinheit (270) umfasst, eingerichtet um zu ermitteln, ob das Feldgerät (200) in der ersten oder der zweiten Ausrichtung am zweiten Gehäuseteil (310) angeordnet ist.

8. Befestigungssystem (100) nach Anspruch 7, wobei die Lageerfassungseinheit (270) einen Reed-Kontakt oder einen Hall-Sensor umfasst, der eingerichtet ist, um mit einer am Befestigungsadapter angeordneten Magneteinheit (350) wechselzuwirken, um die Ausrichtung des Feldgeräts (200) zu ermitteln.

9. Befestigungssystem (100) nach einem der vorhergehenden Ansprüche, wobei das Feldgerät (200) eine Füllstandsmesseinheit ist, die eingerichtet ist, einen Füllstand basierend auf einer Laufzeitmessung eines abgestrahlten und auf die Füllstandsmesseinheit reflektierten Signals, vorzugsweise ein Radarsignal oder ein Mikrowellensignal, zu bestimmen.

10. Befestigungssystem (100) nach einem der Ansprüche 7 bis 9, wobei das Feldgerät (200) eingerichtet ist, bei der Signalauswertung zu berücksichtigen, ob das Feldgerät in der ersten oder zweiten Ausrichtung angeordnet ist.

11. Befestigungssystem (100) nach einem der vorhergehenden Ansprüche, wobei eine Ausrichtung des Feldgeräts für eine Anordnung des Befestigungssystems (100) innerhalb eines Behälters und eine Ausrichtung des Feldgeräts für eine Anordnung des Befestigungssystems (100) außerhalb eines bzw. an einem Behälter(s) vorgesehen ist.

12. Verwendung eines Befestigungsadapters (300), umfassend ein Gehäuseteil zur verliersicheren Aufnahme eines Gehäuseteils eines Feldgeräts (200) in einem Befestigungssystem (100) nach einem der Ansprüche 1 bis 11 und/oder Verwendung eines Feldgeräts (200), umfassend ein Gehäuseteil zur verliersicheren Aufnahme in einem Gehäuseteil eines Befestigungsadapters (300) in einem Befestigungssystem (100) nach einem der Ansprüche 1 bis 11.

## Claims

1. A mounting system (100) for a field device (200), comprising:
at least one field device (200) comprising a first housing part (230);
at least one mounting adapter (300) comprising a second housing part (310) for captively receiving the first housing part (230);
wherein one of the first and the second housing parts (230, 310) comprises first mounting means (240) and second mounting means (250) and the other of the first and the second housing parts (230, 310) comprises third mounting means (340);
wherein the mounting means are arranged such that the field device (200) is engageable with the second housing part (310) in a first orientation and with the second housing part (310) in a second orientation;
wherein the third mounting means (340) are engageable with the first mounting means (240) in a first orientation of the field device (200) and engageable with the second mounting means (250) in a second orientation of the field device (200).

2. Mounting system (100) according to claim 1, wherein the first mounting means (240) and the second mounting means (250) are provided on the first housing part (230) and the third mounting means (340) are provided on the second housing part (310).

3. Mounting system (100) according to any one of the preceding claims 1 or 2, wherein the first and the second mounting means (240, 250) are arranged on opposite sides of the first housing part (230), and wherein it is preferred that the mounting means (240, 250, 340) are arranged in corner regions of the first housing part (230) and/or in corner regions of a reception (320) of the second housing part (310).

4. Mounting system (100) according to any one of the preceding claims 1 to 3, wherein the first and the second mounting means (240, 250) are arranged mirror-symmetrically with respect to a plane (260), so that the field device (200) can be arranged on the second housing part (310) in the first orientation rotated by 180° DEG with respect to the second orientation.

5. Mounting system (100) according to any one of the preceding claims, wherein the mounting means (240, 250, 340) are configured as corresponding snap-in connections, bayonet connections, snap-on connections, spring/groove connections and/or screw connections.

6. Mounting system (100) according to one of the preceding claims, wherein the first housing part (230) of the field device (200) is receivable in the second housing part (310) of the mounting adapter (200) in such a way that both housing parts (230, 310) form a common base surface (330) in the connected state, wherein the formed base surface (330) is preferably a planar surface (330) or a curved surface.

7. Mounting system (100) according to any one of the preceding claims, wherein the field device (200) comprises a position detection unit (270) arranged to determine whether the field device (200) is arranged in the first or the second orientation on the second housing part (310).

8. Mounting system (100) according to claim 7, wherein the position detection unit (270) comprises a reed contact or a Hall sensor arranged to interact with a magnetic unit (350) arranged on the mounting adapter to determine the orientation of the field device (200).

9. Mounting system (100) according to any one of the preceding claims, wherein the field device (200) is a level measurement unit arranged to determine a level based on a time-of-flight measurement of a radiated signal reflected onto the level measurement unit, preferably a radar signal or a microwave signal.

10. Mounting system (100) according to any one of claims 7 to 9, wherein the field device (200) is arranged to take into account whether the field device is arranged in the first or second orientation during the signal evaluation.

11. Mounting system (100) according to any one of the preceding claims, wherein one orientation of the field device is for arranging the mounting system (100) inside a container and one orientation of the field device is for arranging the mounting system (100) outside a container(s).

12. Use of a mounting adapter (300) comprising a housing part for captively receiving a housing part of a field device (200) in a mounting system (100) according to any one of claims 1 to 11 and/or use of a field device (200) comprising a housing part for captively receiving a housing part of a mounting adapter (300) in a mounting system according to any one of claims 1 to 11.

## Revendications

1. Système de fixation (100) pour un appareil de terrain (200), comprenant :
au moins un appareil de terrain (200) comprenant une première partie de boîtier (230) ;
au moins un adaptateur de fixation (300), comprenant une deuxième partie de boîtier (310) pour recevoir de manière imperdable la première partie de boîtier (230) ;
dans lequel l'une des première et deuxième parties de boîtier (230, 310) comprend un premier moyen de fixation (240) et un deuxième moyen de fixation (250) et l'autre des première et deuxième parties de boîtier (230, 310) comprend un troisième moyen de fixation (340) ;
dans lequel les moyens de fixation sont disposés de telle sorte que l'appareil de terrain (200) peut être mis en prise avec la deuxième partie de boîtier (310) dans une première orientation et avec la deuxième partie de boîtier (230) dans une deuxième orientation ;
dans lequel le troisième moyen de fixation (340) peut être mis en prise avec le premier moyen de fixation (240) dans une première orientation de l'appareil de terrain (200) et avec le deuxième moyen de fixation (250) dans une deuxième orientation de l'appareil de terrain (200).

2. Système de fixation (100) selon la revendication 1, dans lequel le premier moyen de fixation (240) et le deuxième moyen de fixation (250) sont prévus sur la première partie de boîtier (230) et le troisième moyen de fixation (340) est prévu sur la deuxième partie de boîtier (310).

3. Système de fixation (100) selon l'une des revendications précédentes 1 ou 2, dans lequel le premier et le deuxième moyen de fixation (240, 250) sont disposés sur des côtés opposés de la première partie de boîtier (230), et dans lequel il est préféré que les moyens de fixation (240, 250, 340) soient disposés dans des coins de la première partie de boîtier (230) et/ou dans des coins d'un réceptacle (320) de la deuxième partie de boîtier (310).

4. Système de fixation (100) selon l'une des revendications précédentes 1 à 3, dans lequel le premier et le deuxième moyen de fixation (240, 250) sont disposés symétriquement par rapport à un plan (260), de sorte que l'appareil de terrain (200) peut être disposé sur la deuxième partie de boîtier (310) dans la première orientation tournée de 180° DEG par rapport à la deuxième orientation.

5. Système de fixation (100) selon l'une des revendications précédentes, dans lequel les moyens de fixation (240, 250, 340) sont réalisés sous la forme de liaisons à encliquetage, de liaisons à baïonnette, de liaisons à enclenchement, de liaisons à rainure et languette et/ou de liaisons à vis qui se correspondent.

6. Système de fixation (100) selon l'une des revendications précédentes, dans lequel la première partie de boîtier (230) de l'appareil de terrain (200) peut être reçue dans la deuxième partie de boîtier (310) de l'adaptateur de fixation (200) de telle sorte que les deux parties de boîtier (230, 310) forment une surface de base (330) commune à l'état relié, la surface de base formée (330) étant de préférence une surface plane (330) ou une surface courbe.

7. Système de fixation (100) selon l'une des revendications précédentes, dans lequel l'appareil de terrain (200) comprend une unité de détection de position (270) conçue pour déterminer si l'appareil de terrain (200) est disposé dans la première ou la deuxième orientation sur la deuxième partie de boîtier (310).

8. Système de fixation (100) selon la revendication 7, dans lequel l'unité de détection de position (270) comprend un contact Reed ou un capteur à effet Hall conçu pour interagir avec une unité magnétique (350) disposée sur l'adaptateur de fixation pour déterminer l'orientation de l'appareil de terrain (200).

9. Système de fixation (100) selon l'une des revendications précédentes, dans lequel l'appareil de terrain (200) est une unité de mesure de niveau de remplissage conçue pour déterminer un niveau de remplissage sur la base d'une mesure de temps de propagation d'un signal émis et réfléchi sur l'unité de mesure de niveau de remplissage, de préférence un signal radar ou un signal micro-ondes.

10. Système de fixation (100) selon l'une des revendications 7 à 9, dans lequel l'appareil de terrain (200) est conçu pour prendre en compte le fait que l'appareil de terrain est disposé dans la première ou la deuxième orientation lors de l'évaluation du signal.

11. Système de fixation (100) selon l'une des revendications précédentes, dans lequel une orientation de l'appareil de terrain est prévue pour une disposition du système de fixation (100) à l'intérieur d'un récipient et une orientation de l'appareil de terrain pour une disposition du système de fixation (100) à l'extérieur ou sur un récipient.

12. Utilisation d'un adaptateur de fixation (300) comprenant une partie de boîtier pour recevoir de manière imperdable une partie de boîtier d'un appareil de terrain (200) dans un système de fixation (100) selon l'une des revendications 1 à 11 et/ou utilisation d'un appareil de terrain (200) comprenant une partie de boîtier pour recevoir de manière imperdable dans une partie de boîtier un adaptateur de fixation (300) dans un système de fixation (100) selon l'une des revendications 1 à 11.
